# EUROPEAN PATENT SPECIFICATION

(11) **EP 1 230 712 B1**
(45) Date of publication and mention of the grant of the patent: **27.08.2003**
(21) Application number: 00985034.8
(22) Date of filing: 13.11.2000
(51) Int. Cl.: H01R 12/18, H01R 12/20

(54) **Electrical connector**
Elektrischer Verbinder
Connecteur électrique

(30) Priority: 15.11.1999 NL 1013576
(43) Date of publication of application: 14.08.2002
(73) Proprietor: F.C.I. - Framatome Connectors International, 92084 Paris La Défense Cedex (FR)
(72) Inventor: LOMAN, Martinus, Hendricus, NL-5345 AV Oss (NL)
(74) Representative: de Vries, Johannes Hendrik Fokke
(86) International application number: EP0011287
(87) International publication number: WO01037378

(56) References cited:
- EP-A- 0 930 812
- US-A- 5 171 154

## Description

The invention relates to an electrical connector, comprising a housing of insulating material, the housing having a mounting surface with means for mounting the housing on the surface of a printed circuit board.

EP-A-0 930 812 discloses an electrical connector of this type, wherein the mounting means is provided in the form of a metal plate mounted on the mounting surface. The mounting surface is provided with pegs, wherein the metal plate is fixed by melting the pegs. The known manner of fixation of the metal plate to the housing is disadvantageous as heating the pegs causes degeneration of the insulation material resulting in an unreliable fixation of the metal plate and/or problems regarding location or fixation of the contact elements accommodated in the housing. Moreover the fixation step in manufacturing the connector is relatively time consuming and involves relatively high production cost.

The invention aims to provide an improved electrical connector of the above-mentioned type.

To this end the electrical connector of the invention is characterized in that the mounting surface is provided with a plurality of grooves, each groove having a groove entrance directed away from the mounting surface, wherein a metal connection element is mounted in each groove by clamping, which connection element is accessible through the groove entrance.

In this manner an electrical connector is obtained, wherein the connection elements providing the surface mount connection to the printed circuit board are mounted in the grooves by a simple clamping connection. Manufacturing cost of the connector are thereby reduced, whereas a reliable connection is nevertheless guaranteed.

In a first embodiment the metal connection elements are made as solid rods.

Preferably, the metal connection elements are made as hollow tubes with at least one opening accessible through the groove entrance and connecting the hollow inner side of the tube with the environment. In particular this embodiment allows a very strong interconnection between the connection elements and the housing as the tubes can be relatively resilient, whereas after the soldering step for connecting the connector to the printed circuit board, the hollow tubes will be filled with soldering material resulting in solid tubes which can not be removed from the grooves.

The invention will be further explained by reference to the drawings in which two embodiments of the connector of the invention are schematically shown.

Fig. 1 is perspective view of an embodiment of the connector of the invention showing the mounting surface of the connector.

Figs. 2- 4 show details of the connector of fig. 1.

Fig. 5 shows the connector of fig. 1 mounted on a printed circuit board with two details at a larger scale showing the solder interconnection between the connection elements and the printed circuit board.

Fig. 6 shows a perspective view of a second embodiment of the connector of the invention, wherein the connection elements are shown before assembly with the connector.

Fig. 7 shows a perspective view corresponding to fig. 6 with the connection elements mounted in the grooves of the mounting surface.

Figs. 8A-8C show the mounting step of a connection element in the embodiment of fig. 6.

Fig. 9 shows the connector of fig. 7 as mounted on a printed circuit board with two details at a larger scale.

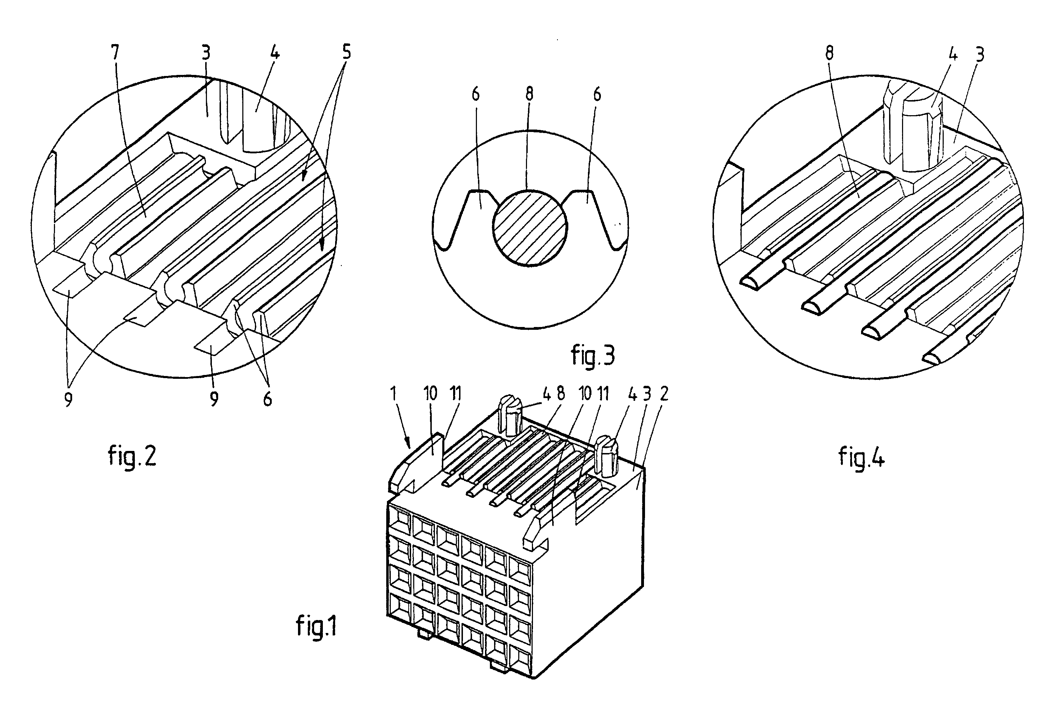

Fig. 1 shows a perspective view of a connector 1 comprising a housing 2 of insulating material. The housing 2 has a mounting surface 3 having two projecting spring-type pegs 4 for holding the connector 1 on the surface of a printed circuit board before making a solder connection.

The mounting surface 3 of the housing 2 is provided with a plurality of grooves 5 having upstanding side walls 6 as can be seen in figs. 2 and 3 in particular. The outer ends of the upstanding side walls 6 determine a groove entrance 7 directed away from the mounting surface 3. A connection element 8 is mounted in each groove 5 by pressing the connection element through the groove entrance 7 into the groove. The upstanding side walls 6 will resiliently deform so that the connection element 8 will be received in the groove 5 as shown in fig. 3.

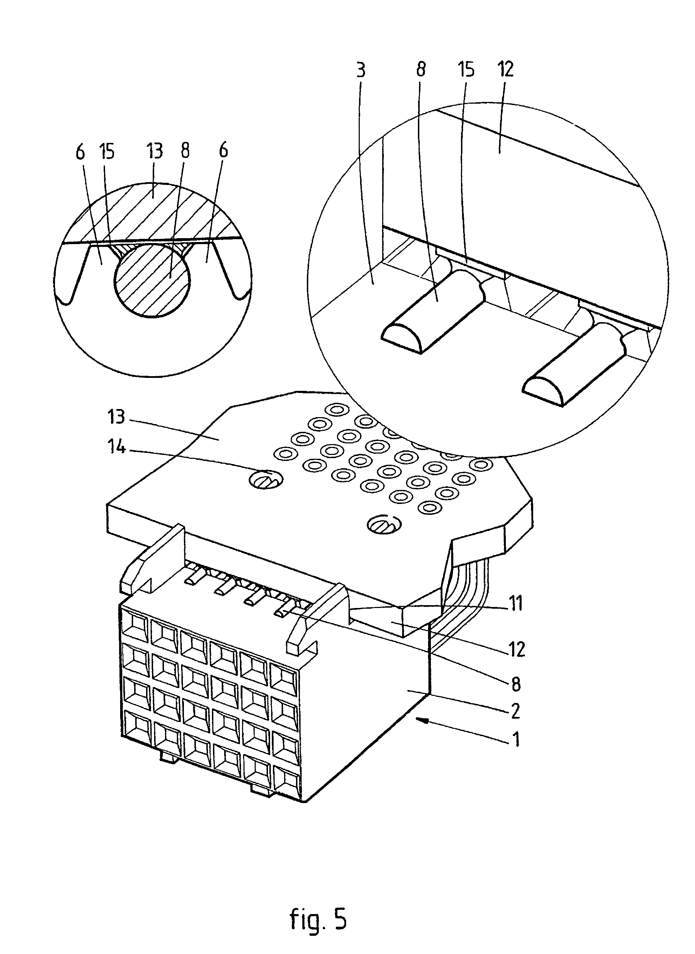

In case of the connector shown in fig. 1, the connection elements 8 are made as solid metal rods. The solid metal rods are pre-tinned, i.e. provided with a tin coating before mounting the rods into the grooves 5. The rods 8 are clamped within the grooves 5 as the diameter of the rods 8 fits clampingly within the groove 5, wherein the width of a groove entrance 7 is smaller than the diameter of the rod 8. As can be seen in fig. 1-4, the rods 8 extend into groove extensions 9 which are made in a part of the mounting surface 3 between two upstanding elements 10 determining a stop 11 co-operating with an edge 12 of a printed circuit board 13 shown in fig. 5.

Fig. 5 shows the connector 1 of fig. 1 as mounted on the printed circuit board 13, wherein the pegs 4 are received in corresponding passages 14 of the printed circuit board 13. On the surface of the printed circuit board 13 directed towards the mounting surface 3 circuit tracks 15 are provided adapted to co-operate with the rods 8 mounted in the grooves 5. These circuit tracks 15 are provided with a solder paste in a usual manner. For making the solder connection, the solder paste is heated and as the rods 8 extend beyond the edge 12 of the printed circuit board 13, the heat received by the ends of the rods 8 allow a rapid absorption of heat energy and subsequent transmission of the heat along the complete length of the rods 8. In this manner a reliable interconnection between the rods 8 and the circuit tracks 15 is obtained a shown in the details at a larger scale of fig. 5.

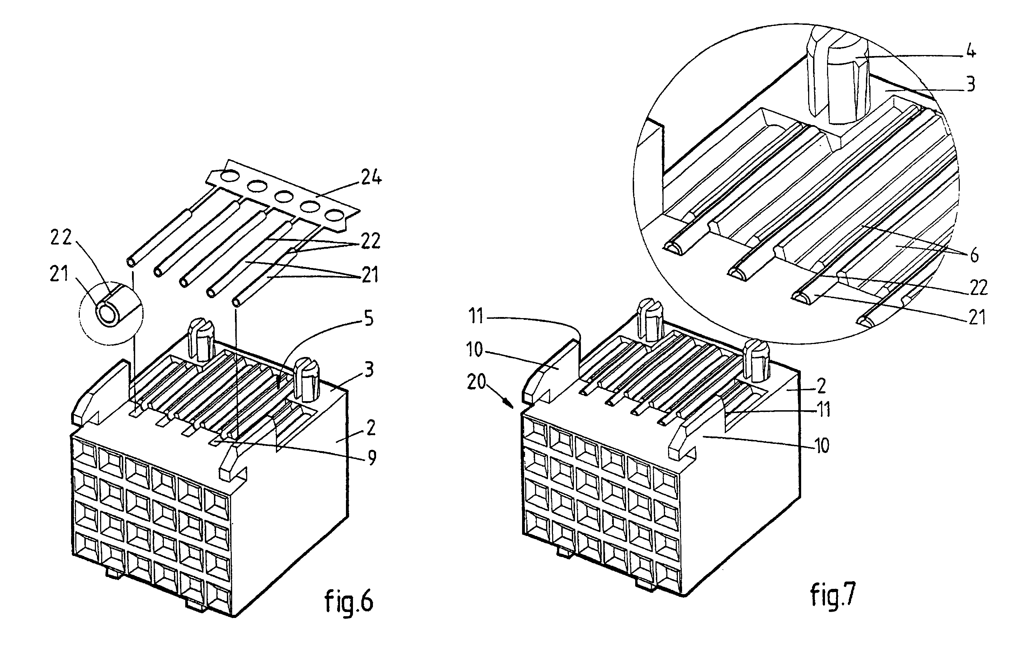

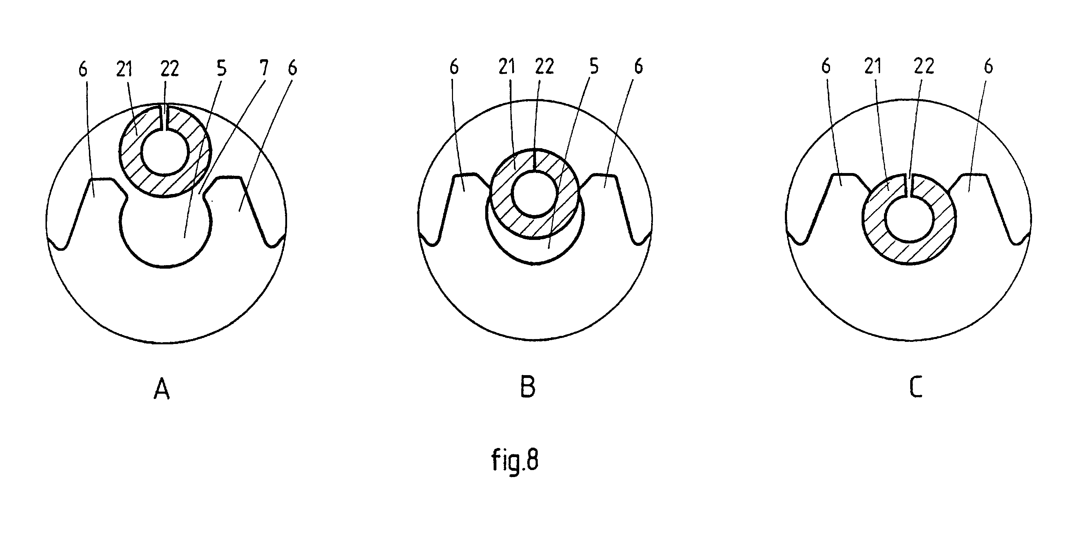

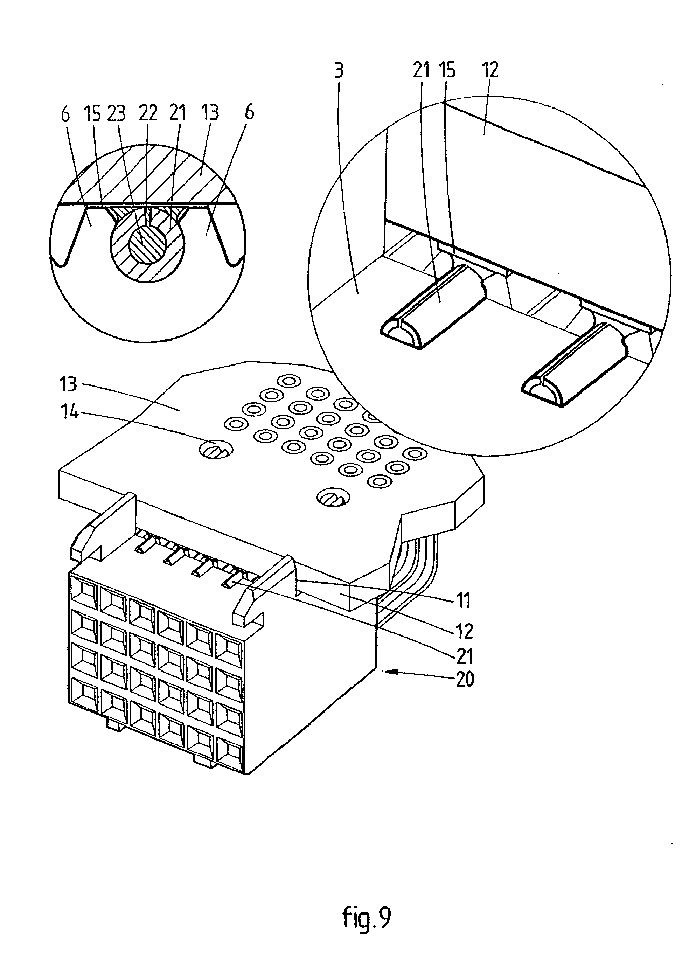

Figs. 6-9 show a second embodiment of the connector of the invention which mainly corresponds to the embodiment of figs. 1-5, wherein corresponding elements are indicated by the same reference numerals. The connector 20 shown in figs. 6-9 comprises the same housing 2 as the connector 1 of figs. 1-5. In this case the connection elements are made as hollow tubes 21 having at least one opening 22 which is accessible through the groove entrance 7 when the hollow tubes 21 are mounted in the grooves 5. The opening 22 of the tubes 21 connect the hollow inner side of the tube with the environment. This opening 22 is made as a longitudinal slot in the embodiment shown in figs. 6-9. As shown in particular in figs. 8A-8C the longitudinal slot 22 provides the tube 21 with a cross-section which can be decreased by resilient deformation during mounting the tube 21 in a groove 5. In fig. 8B the tube 21 is compressed by the upstanding side walls 6 such that the longitudinal slot 22 is substantially closed. When the tube 21 is completely received within the groove 5, the tube 21 flexes outwardly again to open the slot 22. In this manner the situation of fig. 7 is obtained showing the connector 20 before mounting the same on the printed circuit board 13. Fig. 9 shows in the same manner as fig. 5 the connector 20 as mounted on the printed circuit board 13. Again, the edge 12 of the printed circuit board 13 engages the stops of the elements 10 so that the hollow tubes 21 extend beyond the printed circuit board 13 and thereby allow a rapid absorption of energy to provide a re-flow of the solder paste on the circuit tracks 15. The tubes 21 are tinned both on the outer and inner sides. Through re-flowing the solder paste, the soldering material will flow into the hollow inner side of the tubes 21 as indicated by reference numeral 23 resulting in a solid connection element after the soldering step. In this manner a very rigid anchorage of the connection elements in the grooves 5 of the housing 2 is obtained.

The hollow tubes 21 can be made from a flat metal strip by stamping an deforming in a manner known per se. In fig. 6 the tubes 21 are still interconnected to a strip 24, wherein they are separated from the strip 24 when they are assembled with the housing. In the embodiments shown the connection elements have different lengths. Of course, all connection elements may have the same length. In the embodiment of fig. 1-5 the connection elements can be cut off from tinned wires.

The invention is not restricted to the above described embodiments which can be varied in a number of ways within the scope of the claims.

## Claims

1. Electrical connector comprising a housing (2) of insulating material, the housing having a mounting surface (3) with means (4) for mounting the housing to a printed circuit board, **characterized in that** the mounting surface is provided with a plurality of grooves (5), each groove having a groove entrance (7) directed away from the mounting surface, wherein a metal, electrical connection element (8) is mounted in each groove by clamping, which connection element is accessible through the groove entrance.

2. Electrical connector according to claim 1, wherein the metal, electrical connection elements (8) are tinned.

3. Electrical connector according to claims 1 or 2, wherein the grooves (5) have upstanding side walls (6) engaging partially around the metal electrical connection elements.

4. Electrical connector according to claim 3, wherein the outer ends of the upstanding side walls (6) of the grooves (5) determine the groove entrance having a width smaller than the width of the cross-section of a metal, electrical connection element (8).

5. Electrical connector according to any one of the preceding claims, wherein the mounting surface is provided with at least one stop element (11) adapted to co-operate with an edge of the printed circuit board, wherein the metal, electrical connection elements (8) extend beyond the stop element.

6. Electrical connector according to any one of the preceding claims, wherein the metal, electrical connection elements (8) are made as solid rods.

7. Electrical connector according to any one claims 1-5, wherein the metal, electrical connection elements (8) are made as hollow tubes (21) with at least one opening accessible through the groove entrance (7) and connecting the hollow inner side of the tube with the environment.

8. Electrical connector according to claim 7, wherein the tubes (21) have a longitudinal slot (22), wherein the slot is directed away from the mounting surface of the housing.

9. Electrical connector according to claim 8, wherein the inner wall of the tube (21) is at least partially tinned.

## Patentansprüche

1. Elektrischer Verbinder mit einem Gehäuse (2) aus Isoliermaterial, wobei das Gehäuse eine Montagefläche (3) mit Mitteln (4) zum Montieren des Gehäuses auf eine Leiterplatte aufweist, **dadurch gekennzeichnet, dass** die Montagefläche mehrere Rillen (5) aufweist, wobei jede Rille einen Rilleneingang (7) besitzt, der von der Montagefläche weg ausgerichtet ist, wobei ein metallisches elektrisches Anschlusselement (8) in jeder Rille durch Klemmung montiert ist, wobei dieses Anschlusselement über den Rilleneingang zugänglich ist.

2. Elektrischer Verbinder nach Anspruch 1, bei dem die metallischen elektrischen Anschlusselemente (8) verzinnt sind.

3. Elektrischer Verbinder nach Anspruch 1 oder 2, bei dem die Rillen (5) hochstehende Seitenwände (6) aufweisen, welche die metallischen elektrischen Anschlusselemente teilweise umgreifen.

4. Elektrischer Verbinder nach Anspruch 3, bei dem die äußeren Enden der hochstehenden Seitenwände (6) der Rillen (5) den Rilleneingang bestimmen, dessen Breite geringer ist als die Breite des Querschnitts eines metallischen elektrischen Anschlusselements (8).

5. Elektrischer Verbinder nach einem der vorhergehenden Ansprüche, bei dem die Montagefläche mit mindestens einem Anschlagelement (11) versehen ist, das mit einer Kante der Leiterplatte zusammenwirken kann, wobei die metallischen elektrischen Anschlusselemente (8) sich über das Anschlagelement hinaus erstrecken.

6. Elektrischer Verbinder nach einem der vorhergehenden Ansprüche, bei dem die metallischen elektrischen Anschlusselemente (8) als massive Stangen ausgebildet sind.

7. Elektrischer Verbinder nach einem der Ansprüche 1 bis 5, bei dem die metallischen elektrischen Anschlusselemente (8) als hohle Rohre (21) ausgebildet sind, die mindestens eine Öffnung aufweisen, welche durch den Rilleneingang (7) zugänglich ist und die hohle Innenseite des Rohrs mit der Umgebung verbindet.

8. Elektrischer Verbinder nach Anspruch 7, bei dem die Rohre (21) einen Längsschlitz (22) aufweisen, wobei der Schlitz von der Montagefläche des Gehäuses weg ausgerichtet ist.

9. Elektrischer Verbinder nach Anspruch 8, bei dem die Innenwand des Rohrs (21) zumindest teilweise verzinnt ist.

## Revendications

1. Connecteur électrique, comprenant un logement (2) en un matériau isolant, le logement ayant une surface de montage (3) avec des moyens (4) pour monter le logement sur une carte de circuit imprimé, **caractérisé en ce que** la surface de montage est munie d'une pluralité de rainures (5), chaque rainure ayant une entrée de rainure (7) dirigée à l'opposé de la surface de montage, dans lequel un élément métallique de connexion électrique (8) est monté, par serrage, dans chaque rainure, lequel élément de connexion est accessible par l'entrée de la rainure.

2. Connecteur électrique selon la revendication 1, dans lequel les éléments métalliques de connexion électrique (8) sont étamés.

3. Connecteur électrique selon la revendication 1 ou 2, dans lequel les rainures (5) ont des parois latérales verticales (6) venant partiellement au contact des éléments métalliques de connexion électrique.

4. Connecteur électrique selon la revendication 3, dans lequel les extrémités extérieures des parois latérales verticales (6) des rainures (5) déterminent l'entrée de rainure ayant une largeur inférieure à la largeur de la section transversale d'un élément métallique de connexion électrique (8).

5. Connecteur électrique selon une quelconque des revendications précédentes, dans lequel la surface de montage est munie d'au moins un élément d'arrêt (11) adapté à coopérer avec un bord de la carte de circuit imprimé, dans lequel les éléments métalliques de connexion électrique (8) s'étendent au-delà de l'élément d'arrêt.

6. Connecteur électrique selon une quelconque des revendications précédentes, dans lequel les éléments métalliques de connexion électrique (8) sont constitués comme des barres pleines.

7. Connecteur électrique selon une quelconque des revendications 1 à 5, dans lequel les éléments métalliques de connexion électrique (8) sont constitués comme des tubes creux (21) avec au moins une ouverture, accessible par l'entrée de la rainure (7) et reliant le côté intérieur creux du tube avec l'environnement.

8. Connecteur électrique selon la revendication 7, dans lequel les tubes (21) comportent une fente longitudinale (22) et dans lequel la fente est dirigée à l'opposé de la surface de montage du logement.

9. Connecteur électrique selon la revendication 8, dans lequel la paroi intérieure du tube (21) est au moins partiellement étamée.
